# EUROPEAN PATENT APPLICATION

(11) **EP 4 617 958 A1**
(43) Date of publication of application: **17.09.2025**
(21) Application number: 25163139.6
(22) Date of filing: 12.03.2025
(51) Int. Cl.: G06N 10/40, H10N 69/00

(54) **FLUX LINE GROUNDING FOR QUANTUM PROCESSOR**

(30) Priority: 12.03.2024 FI 20245296
(71) Applicant: IQM Finland Oy, 02150 Espoo (FI)
(72) Inventor: LANDRA, Alessandro, 02150 Espoo (FI); GUTHRIE, Andrew, 02150 Espoo (FI); VEPSÄLÄINEN, Antti, 02150 Espoo (FI)
(74) Representative: Berggren Oy

(57) **Abstract**

There is provided mitigating crosstalk from grounding of flux lines in superconducting chips. A superconducting chip, or chip package, comprises at least one qubit (102) on a first substrate (104); at least one flux line (106) comprising an antinode for current in proximity of the at the at least one qubit; at least one termination to the ground (105) on an opposite side of the first substrate (104, 406) with respect to the at least one qubit or on a second substrate (406) stacked with the first substrate (104); and a conductor arrangement (108, 110, 808) connected to said one end of the flux line and arranged to route the flux line to the at least one termination to the ground (105).

## Description

### FIELD OF THE INVENTION

The invention is generally related to the field of quantum computing. In particular, the invention is related to grounding of flux lines carrying control signals for qubit manipulation.

### BACKGROUND OF THE INVENTION

A quantum computing device, also referred to as a quantum computer, uses quantum mechanical phenomena, such as superposition and entanglement, to perform required quantum computing operations. Unlike a conventional computer that manipulates information in the form of bits (e.g., "1" or "0"), the quantum computer manipulates information using qubits. A qubit may refer not only to a basic unit of quantum information but also to a quantum device that is used to store one or more qubits of information (e.g., the superposition of "0" and "1").

Quantum computing devices are implemented by superconducting circuits that typically use frequency multiplexed qubit readout using one or more resonators per qubit, where multiple qubits are read out by a single shared probe line. The qubits may be coupled to the single shared probe line by a readout resonator and one or more Purcell-filter resonators. The resonators should be tuned relative to each to each other for accurate and reliable readout of the qubit states.

Qubit manipulation is used in quantum computers for performing quantum operations. Transmission lines, or flux lines, are used to carry control signals, whose magnetic filed is coupled to the qubits for manipulating the qubits. Grounding the flux lines on the same plane near the qubits can cause current propagation on qubit plane and crosstalk to other flux lines and qubits. For example, DC (Direct Current) may cause crosstalk to qubit/couplers tuning and AC (Alternating Current) may cause cross talk for two qubit gates operations. In large quantum processing units, the number of qubits can be 20 or more, whereby flux lines and qubits can be close to each other which can lead to increased crosstalk.

### SUMMARY

This summary is provided to introduce a selection of concepts in a simplified form that are further described below in the detailed description. This summary is not intended to identify key features of the invention, nor is it intended to be used to limit the scope of the invention.

The objective of the invention is to provide a technical solution to improve distribution of super currents from a signal conductor of co-planar waveguide to the ground in an arrangement for a superconducting chip.

The objective above is achieved by the features of the independent claims in the appended claims. Further embodiments and examples are apparent from the dependent claims, the detailed description and the accompanying drawings.

According to a first aspect, there is provided a superconducting chip, or chip package, comprising:
- at least one qubit on a first substrate;
- at least one flux line comprising an antinode for current in proximity of the at the at least one qubit;
- at least one termination to the ground on an opposite side of the first substrate with respect to the at least one qubit or on a second substrate stacked with the first substrate; and
- a conductor arrangement connected to said one end of the flux line and arranged to route the flux line to the at least one termination to the ground.

According to a second aspect there is provided a quantum computing apparatus comprising at least one superconducting chip, or chip package, according to an aspect and a control unit connected to the at least one superconducting chip, or chip package, and the control unit is configured to feed one or more control signals to at least one flux line for manipulating at least one qubit.

At least some aspects provide mitigating crosstalk from grounding of flux lines.

### BRIEF DESCRIPTION OF THE DRAWINGS

The invention is explained below with reference to the accompanying drawings in which:
Fig. 1 illustrate an example of a superconducting circuit;
Figs. 2 and 3 illustrate examples of grounding of a flux line for a control signal in superconducting chips comprising a single substrate, in accordance with at least some embodiments;
Figs. 4 to 11 illustrate examples of grounding of a flux line for a control signal in a superconducting chip package, in accordance with at least some embodiments; and
FIG. 12 shows a block diagram of a quantum computing apparatus in accordance with at least some embodiments.

### DETAILED DESCRIPTION

Various embodiments of the invention are further described in more detail with reference to the accompanying drawings. However, the invention may be embodied in many other forms and should not be construed as limited to any certain structure or function discussed in the following description. In contrast, these embodiments are provided to make the description of the invention detailed and complete. According to the detailed description, it will be apparent to the ones skilled in the art that the scope of the invention encompasses any embodiment thereof, which is disclosed herein, irrespective of whether this embodiment is implemented independently or in concert with any other embodiment of the invention. For example, the chips and apparatus disclosed herein may be implemented in practice by using any numbers of the embodiments provided herein. Furthermore, it should be understood that any embodiment of the invention may be implemented using one or more of the elements presented in the appended claims.

In the present application, similar or corresponding elements and components across different figures and embodiments are referred to using the same reference numbers. The use of consistent reference numbers is intended to denote their similarity or correspondence unless otherwise stated.

The word "exemplary" is used herein in the meaning of "used as an illustration". Unless otherwise stated, any embodiment described herein as "exemplary" should not be construed as preferable or having an advantage over other embodiments.

Any positioning terminology, such as "left", "right", "upper", "lower", etc., may be used herein for convenience to describe one element's or feature's relationship to one or more other elements or features in accordance with the figures. It should be apparent that the positioning terminology is intended to encompass different orientations of the chip disclosed herein, in addition to the orientation (s) depicted in the figures. As an example, if one imaginatively rotates the chip in the figures 90 degrees clockwise, elements or features described as "left" and "right" relative to other elements or features would then be oriented, respectively, "above" and "below" the other elements or features. Therefore, the positioning terminology used herein should not be construed as any limitation of the invention.

Although the numeric terminology, such as "first", "second", etc., may be used herein to describe various embodiments and the features thereof, it should be understood that the embodiments and the features thereof should not be limited by this numerative terminology. This numerative terminology is used herein only to distinguish one embodiment or feature from another embodiment or feature. Thus, a first embodiment discussed below could be called a second embodiment and vice versa, without departing from the teachings of the invention.

The following embodiments are exemplary. Although the specification may refer to "an", "one", or "some" embodiment(s) in several locations, this does not necessarily mean that each such reference is to the same embodiment(s), or that the feature only applies to a single embodiment. Single features of different embodiments may also be combined to provide other embodiments.

As used herein, "at least one of the following" and "at least one of" and similar wording, where the list of two or more elements are joined by "and" or "or", mean at least any one of the elements, or at least any two or more of the elements, or at least all the elements.

As used in the embodiments disclosed herein, a qubit may refer to a superconducting quantum device, or a superconducting element, configured to store one or more quantum bits of information (or qubits for short). In this sense, the qubit serves as a quantum information storage and processing device. The source of nonlinearity in the qubit may be represented by one or more Josephson junctions. The term "Josephson junction" is used herein in its ordinary meaning and may refer to a quantum mechanical device made of two superconducting electrodes which are separated by a barrier (e.g., a thin insulating tunnel barrier, normal metal, semiconductor, ferromagnet, etc.).

According to the embodiments disclosed herein, a quantum computing apparatus, also referred to as a quantum computer, may refer to an apparatus that comprises at least one superconducting chip and a control unit connected to the at least one superconducting chip, and the control unit is configured to feed one or more control signals at least one flux line for manipulating at least one qubit. Manipulation the at least one qubit, or more generally qubit manipulation, facilitates the quantum computing apparatus to perform quantum computing operations, such as reading the state of a qubit, initializing the state of the qubit, and entangling the state of the qubit with the states of other qubits in the quantum computing apparatus, etc. Existing implementation examples of such quantum computing apparatuses may include superconducting quantum computers, trapped ion quantum computers, quantum computers based on spins in semiconductors, quantum computers based on cavity quantum electrodynamics, optical photon quantum computers, quantum computers based on defect centers in diamond, etc. The readout may be a frequency-multiplexed readout of the qubits connected to a common feedline by resonator structures.

As used in the embodiments disclosed herein, a flux line is used interchangeably to refer to a transmission line that is arranged to couple a control signal to at least one qubit in a superconducting chip or a superconducting chip package. The control signal may be a microwave signal, for example a DC signal or AC signal.

The exemplary embodiments disclosed herein provide a technical solution that allows mitigating or even eliminating the above-sounded drawbacks of the prior art.

Superconducting circuit refers to a collection of interconnected superconducting elements that work together to perform a specific function. These circuits are typically fabricated on a substrate using superconducting materials, such as niobium or aluminum, which exhibit zero electrical resistance at very low temperatures. Superconducting circuits can take various forms, such as flux lines, transmission lines, transmission line resonators, co-planar waveguides, Josephson junctions, SQUIDs (Superconducting Quantum Interference Devices), or qubits used in quantum computing. They are designed to exploit the unique properties of superconductors, such as the ability to carry persistent currents and exhibit quantum effects. Superconducting circuits are used in applications like quantum computing, high-speed digital electronics, and ultra-sensitive detectors.

Superconducting chip refers to the physical implementation of a superconducting circuit on a chip-scale device. It involves fabricating a superconducting circuitry on a small semiconductor substrate, often made of silicon or sapphire, using advanced microfabrication techniques. The superconducting chip typically contains multiple superconducting elements, such as flux lines, transmission lines, transmission line resonators, co-planar waveguides, Josephson junctions or SQUIDs, interconnected to form a functional circuit. The chip may also include control and readout electronics, cryogenic cooling infrastructure, and other components necessary for its operation. In the context of quantum computing multiple superconducting qubits may be integrated on a single chip. These qubits can be manipulated and measured collectively to perform quantum computations. Superconducting chips are also used in other applications like analog-to-digital converters, microwave amplifiers, and signal processing systems.

Flip-chip bonding is a packaging technique for electronic devices, particularly in microelectronics and semiconductor industries. It involves the attachment of an integrated circuit (IC) chip directly onto a substrate or another chip, typically using solder bumps or other conductive materials. The term "flip-chip" refers to the orientation of the IC chip during the bonding process. Instead of mounting the chip with its active surface facing up, as done in traditional packaging methods, the chip is flipped over so that its active surface, which contains the circuitry and contact pads, faces downward. This allows for direct electrical connections between the chip and the substrate or other chips. The bonding process involves aligning the solder bumps or conductive contacts on the chip with corresponding pads or traces on the substrate. The chip is then pressed onto the substrate, and the solder bumps are heated, melting the solder and creating electrical and mechanical connections between the chip and the substrate. Once the solder cools and solidifies, it forms a reliable and high-density interconnection between the chip and the substrate.

Qubit plane is a conductive plane of a superconducting chip comprising one more qubit. Flux lines for controlling associated qubits are located on a neighboring conductive plane on the superconducting chip. Each of the flux lines is at one end connected to a source of a control signal and at another end positioned close to a qubit associated with the flux line. In this way a magnetic flux of the control signal may be coupled with the qubit associated with the flux line.

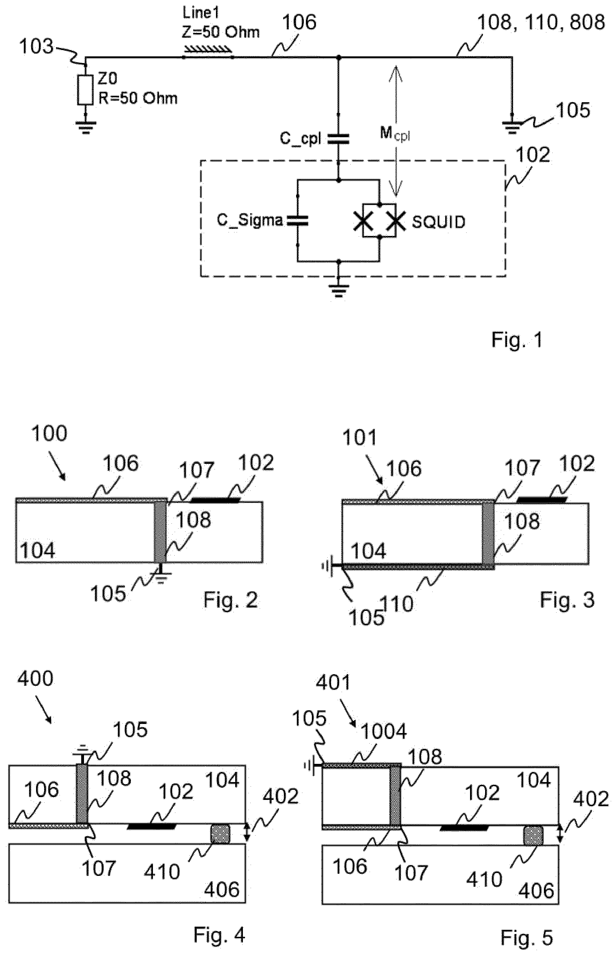

Fig. 1 illustrate an example of a superconducting circuit. The superconducting circuit comprises at least one qubit 102 and a flux line 106 line arranged to couple a control signal to the at least one qubit. The flux line extends longitudinally between opposite ends of the flux line. At one end of the flux line, the flux line is connected to at least one input terminal 103 for receiving a control signal and at another end of the flux line the flux line comprises an antinode for current in proximity of the at the at least one qubit. Thus, the another end, or the antinode, is very close to the at least one qubit for coupling the control signal to the at least one qubit. At the end of the flux line which is close to the at least one qubit, the flux line is arranged to be routed to at least one termination to the ground 105. In an example, at the end of the flux line which is close to the at least one qubit, the flux line may be connected to a conductor arrangement 108, 110, 808 connected to at least one termination to the ground. The at least one termination to the ground may be on an opposite side of the substrate than the at least one qubit, or on another substrate than the at least one qubit, whereby the conductor arrangement is configured to route the flux line off the qubit plane, which facilitates mitigating crosstalk from the grounded flux line to other flux lines and their associated qubits. In an example, of the coupling of the control signal to the at least one qubit 102, the control signal may cause a magnetic flux, M_{cpl}, to the at least one qubit whereby the at least qubit may be manipulated. Connection of the flux line to the ground at the end that is close to the at least one qubit facilitates controlling parasitic coupling, C_{cpl}, that causes Purcell decay. In an example, a superconducting chip or chip package may implement the superconducting circuit, whereby the flux line may be provided on a neighboring plane with the at least one qubit. It should be noted that the flux line is galvanically separated from the at least one qubit and sufficiently close to the at least one qubit at a position, e.g. at a sufficiently close distance, where coupling, M_{cpl}, of a magnetic flux of the control signal to the at least one qubit.

Figs. 2 and 3 illustrate examples of grounding of a flux line for a control signal in superconducting chips comprising a single substrate, in accordance with at least some embodiments. The flux line is routed off the qubit plane and terminated to the ground, whereby crosstalk between the grounded flux line and the qubit plane may be mitigated. The superconducting chips 100, 101 may implement the superconducting circuit of Fig. 1 or at least some elements described with Fig. 1. The examples illustrated in Figs. 2 and 3 may be used in superconducting chip packages that comprises more than one superconducting chip bonded together. Each of the superconducting chips 100, 101 comprises at least one substrate 104 on which there is provided at least one qubit 102 and a flux line 106 arranged to couple a control signal to the qubit. The superconducting chip comprises at least one termination to the ground 105 on an opposite side of the substrate with respect to the at least one qubit 102. The superconducting chip comprises a conductor arrangement 108, 110 connected to the end of the flux line arranged at the at least one qubit. The conductor arrangement 108, 110 is arranged to route the flux line to the at least one termination to the ground 105. The conductor arrangement 108 is configured to extend through the first substrate 104 and connect the flux line 106 to the at least one termination to the ground on the opposite side of the substrate with respect to the at least one qubit 102. In an example in accordance with at least some embodiments, the conductor arrangement 108 comprises a through-silicon via (TSV). In an example, the TSV may be configured to extend through the substrate 104 between opposite surfaces of the substrate. In an example in accordance with at least some embodiments, the conductor arrangement 110 comprises a through-silicon via and a conductor line configured to connect the TSV to the at least one termination to the ground. In an example, the TSV may be configured to extend through the substrate 104 between opposite surfaces of the substrate and the conductor line may extend between an end of the TSV at an opposite side of the substrate than the at least one qubit and the at least one termination to the ground. In an example, the at least one termination to the ground 105 may be positioned on an opposite side of the substrate 104 than the at least one qubit at an edge of the first substrate 104.

Figs. 4 to 11 illustrate examples of grounding of a flux line for a control signal in a superconducting chip package, in accordance with at least some embodiments. The flux line is routed off a qubit plane and terminated to the ground, whereby crosstalk between the grounded flux line and other flux lines and their associated qubits may be mitigated. The superconducting chip package comprises superconducting chips that are bonded together to form the chip package. Referring to Figs. 4 and 5, each of the superconducting chip packages 400, 401 in Figs. 4 and 5 comprise a first substrate 104, where grounding of a flux line for a control signal is arranged similar to described for the superconducting chips with Figs. 2 and 3 with the differences that the superconducting chip packages comprise bonded substrates and the substrate 104 is vertically flipped with respect to the superconducting chips illustrated with Figs. 2 and 3. Accordingly, the superconducting chip package 400 comprises a further substrate 406, or a second substrate, that is bonded by one or more bonding elements 410 to the first substrate 104, where the qubit 102 has been provided. Similarly, the superconducting chip package 401 comprises a further substrate 406, or a second substrate, that is bonded by one or more bonding elements 410 to the first substrate 104, where the qubit 102 has been provided. In this way the superconducting chip packages 400, 401 comprise stacked substrates, where at least one surface of each substrate is facing the other substrate. In an example the stacked substrates may be provided by flip-chip bonding of the substrates 104, 406. In an example, the further substrate 406 and the first substrate 104 are separated by a gap 402 formed between the further substrate 406 and the first substrate 104 by the one or more bonding elements.

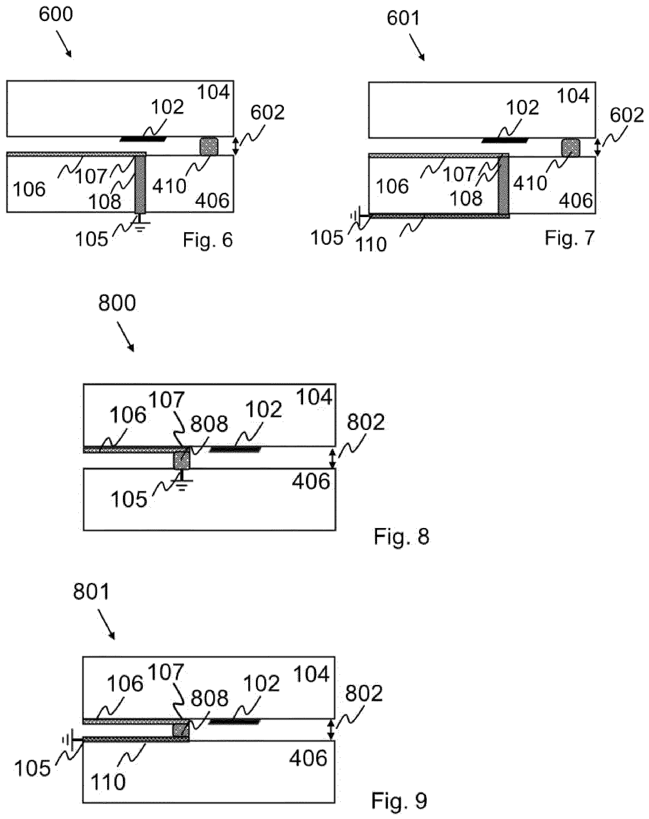

Referring to Figs. 6 and 7, each of the superconducting chip packages 600, 601 in Figs. 6 and 7 comprise superconducting chips that are bonded together to form the chip package. Referring to Figs. 6 and 7, each of the superconducting chip packages 600, 601 in Figs. 6 and 7 comprise a first substrate 104 comprising at least one qubit 102 and a further substrate 406, or a second substrate, that is bonded by one or more bonding elements 410 to the first substrate 104, where the qubit 102 has been provided. The further substrate 406 comprises at least one flux line 106 arranged to couple a control signal to the at least one qubit 102 and at least one termination to the ground 105. The flux line comprises an antinode for current in proximity of the at the at least one qubit. In an example, the antinode for current is the antinode of the current of a control signal carried by the flux line. The antinode may be at an end of the flux line for coupling a control signal to the at least one qubit. In an example, the end of the flux line is arranged on the further substrate under the at least one qubit at the first substrate. Accordingly, the end of the flux line may be positioned on a side of the further substrate 406 facing the first substrate, whereby the flux line may be coupled with the at least one qubit over a gap 602 between the substrates. In an example, the at least one termination to the ground 105 is on an opposite side of the further substrate with respect to the at least one qubit 102, whereby the at least one termination to the ground is separated from the first substrate by the further substrate and the gap 602 between the first substrate and the further substrate. In an example, the flux line 106 may be positioned to a side of the further substrate 406 that is facing the first substrate 104. Each of the superconducting chip packages 600, 601 may comprise a conductor arrangement 108, 110 connected to said one end of the flux line, i.e. to position of the antinode, and arranged to route the flux line to the at least one termination to the ground 105. In an example in accordance with at least some embodiments, the conductor arrangement 108, 110 is configured to extend through the second substrate 406 and connect the flux line 106 to the at least one termination to the ground 105 on the opposite side of the second substrate with respect to a side of the further substrate facing the at least one qubit. In an example in accordance with at least some embodiments the conductor arrangement comprises at least one through-silicon via; or a series of at least one through-silicon via and at least one conductor line. In an example, the TSV may be configured to extend through the substrate 104 between opposite surfaces of the substrate. In an example in accordance with at least some embodiments, the conductor arrangement comprises a through-silicon via and a conductor line configured to connect the TSV to the at least one termination to the ground. In an example, the TSV may be configured to extend through the further substrate 406 between opposite surfaces of the further substrate and the conductor line may extend between an end of the TSV at an opposite side of the further substrate than a side of the further substrate facing the at least one qubit and the at least one termination to the ground. In an example, the at least one termination to the ground 105 may be positioned on an opposite side of the further substrate 406 than the at least one qubit at an edge of the further substrate 406.

Referring to Figs. 8 to 11, each of the superconducting chip packages 800, 801, 1000, 1001 in Figs. 8 to 11 comprise a first substrate 104 that comprises at least one qubit 102 on a first substrate and at least one flux line 106 comprising an antinode for current in proximity of the at the at least one qubit, and a further substrate 406, or a second substrate, comprising at least one termination to the ground 105. Each of the superconducting chip packages 800, 801, 1000, 1001 comprise a conductor arrangement 108, 110, 808 connected to said an antinode for current in proximity of the at the at least one qubit, e.g. one end of the flux line, and arranged to route the flux line to the at least one termination to the ground 105. Similar to described with the superconducting chip packages described with Figs. 4, 5, 6 and 7, the superconducting chip packages 800, 801, 1000, 1001 in Figs. 8 to 11 comprise superconducting chips that are bonded together to form the chip package and the superconducting chip packages comprise bonded substrates that are separated by a gap 802. As a difference to the superconducting chip packages 600, 601, the superconducting chip packages 800, 801, 1000, 1001 in Figs. 8 to 11 comprise the at least one qubit 102 and the flux line 106 on the same substrate 104 similar to the superconducting chips described with Figs. 2, 3, 4 and 5. On the other hand, as a difference to the superconducting chip packages 400, 401, 600, 601 the superconducting chip packages 800, 801, 1000, 1001 in Figs. 8 to 11 comprise conductor arrangements that comprise bonding elements that serve for connecting the flux line 106 the at least one termination to the ground 105 on the further substrate. In an example in accordance with at least some embodiments, the conductor arrangement 108, 110, 808 is configured to extend between the first substrate 104 and the second substrate 406; and connect the flux line 106 to the at least one termination to the ground 105 on the second substrate 406. In an example in accordance with at least some embodiments, the conductor arrangement is configured to connect flux line to at least one termination to the ground 105 through at least one of the following: a series of at least one through-silicon via and at least one conductor line; or a series of at least one bonding element, at least one through-silicon via and at least one conductor line. In an example, the TSV may be configured to extend through the further substrate 406 between opposite surfaces of the further substrate and the conductor line may extend between an end of the TSV at an opposite side of the further substrate than a side of the further substrate facing the at least one qubit and the at least one termination to the ground. In an example, the at least one termination to the ground 105 may be positioned on an opposite side of the further substrate 406 than the at least one qubit at an edge of the further substrate 406. In an example, the TSV may be at one end connected to the conductor line and at another end connected to the bonding element.

Examples of materials for conductive layers, or conductive surface layers, or conductor, comprise at least one of the following: copper; or copper oxide; or indium; or germanium; or niobium; aluminum; aluminum oxide; or alloys of one or more of the previous; or other materials that display superconducting behaviour in low temperatures. Examples of the other materials comprise organic engineered materials such as carbon nanotubes. Various engineered silicon-based/ceramic materials are also foreseeable, when made superconducting in chip substrate manufacturing process.

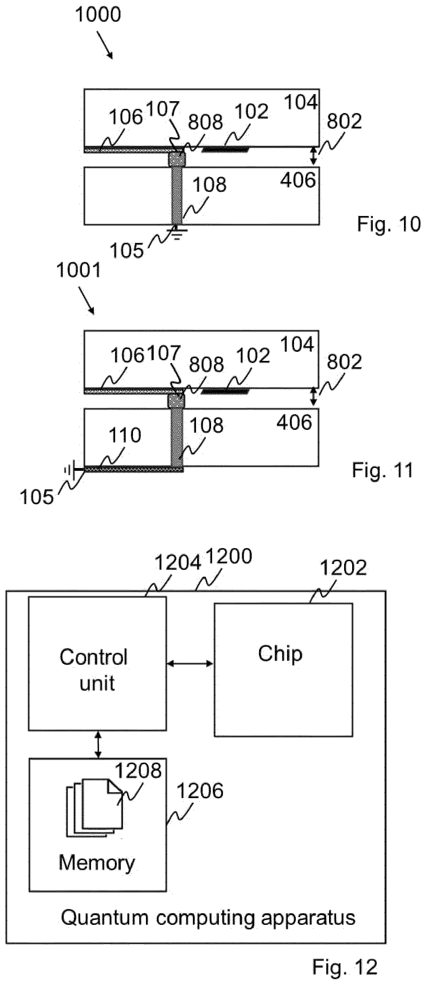

FIG. 12 shows a block diagram of a quantum computing apparatus 1200 in accordance with at least some embodiments. The apparatus 1200 comprises at least one superconducting chip or superconducting chip package 1202 and a control unit 1204. The chip 1202 may comprise one or more superconducting chips or superconducting chip packages described with Figs. 2 to 11. The control unit 1204 is configured to feed one or more control signals to at least one flux line for manipulating at least one qubit.

In an example in accordance with at least some embodiments quantum computing apparatus 1200 comprises at least one superconducting chip or superconducting chip package 1202 comprising at least one arrangement that comprises at least one qubit on a first substrate; at least one flux line comprising an antinode for current in proximity of the at the at least one qubit; at least one termination to the ground on an opposite side of the first substrate with respect to the at least one qubit or on a second substrate stacked with the first substrate ; and a conductor arrangement connected to said antinode for current in proximity of the at the at least one qubit, e.g. one end of the flux line, and arranged to route the flux line to the at least one termination to the ground; and the quantum computing apparatus 1200 further comprises a control unit 1204 connected to the at least one superconducting chip or superconducting chip package and the control unit is configured to feed one or more control signals to at least one flux line for manipulating the at least one qubit. The apparatus 1200 may further comprise a memory 1206 storing executable instructions 1208 which, when executed by the control unit 1204, may cause the control unit 1204 to perform the quantum computing operations. The control unit 1204 may also store the result(s) of the quantum computing operations to the memory 1206. It should be noted that the number, arrangement and interconnection of the constructive elements constituting the apparatus 1200, which are shown in FIG. 12, are not intended to be any limitation of the present disclosure, but merely used to provide a general idea of how the constructive elements may be implemented within the apparatus 1000.

The control unit 1204 may refer a central processing unit (CPU), general-purpose processor, single-purpose processor, microcontroller, microprocessor, application specific integrated circuit (ASIC), field programmable gate array (FPGA), digital signal processor (DSP), complex programmable logic device, etc. It should be also noted that the control unit 1004 may be implemented as any combination of one or more of the aforesaid. As an example, the control unit 1204 may be a combination of two or more microprocessors.

The memory 1006 may be implemented as a classical nonvolatile or volatile memory used in the modern electronic computing machines. As an example, the nonvolatile memory may include Read-Only Memory (ROM), ferroelectric Random-Access Memory (RAM), Programmable ROM (PROM), Electrically Erasable PROM (EEPROM), solid state drive (SSD), flash memory, magnetic disk storage (such as hard drives and magnetic tapes), optical disc storage (such as CD, DVD and Blu-ray discs), etc. As for the volatile memory, examples thereof include Dynamic RAM, Synchronous DRAM (SDRAM), Double Data Rate SDRAM (DDR SDRAM), Static RAM, etc.

The executable instructions 1008 stored in the memory 1206 may be configured as a computer executable code which causes the control unit 1204 to perform the quantum computing operations by using the chip 1202. The computer executable code for carrying out the quantum computing operations may be written in any combination of one or more programming languages, such as Java, C++, or the like. In some examples, the computer executable code may be in the form of a high-level language or in a pre-compiled form, and be generated by an interpreter (also pre-stored in the memory 1006) on the fly.

Electromagnetic couplings between components of superconducting circuit(s), may be, for example, capacitive, inductive, or both capacitive and inductive. In some embodiments, couplings between components are couplings through a space between two chips on which two components are respectively positioned. For example, in some implementations, a qubit positioned on a first substrate may be electromagnetically coupled to a readout resonator positioned on a second substrate that is bump bonded to and facing the first substrate. In some embodiments, couplings are in-plane, with a direction of a coupling electric field and/or magnetic field being substantially in a plane of a side of a chip on which both of two components are positioned. For example, in some implementations, a qubit on a first surface of a silicon substrate may be electromagnetically coupled to a readout resonator on the first surface of the silicon substrate.

Superconducting quantum circuits comprise components for performing computational operations based on quantum operations. Components of the superconducting quantum circuits, also referred to quantum circuit components, or quantum computing circuit components, disclosed herein include circuit components for performing the quantum operations. That is, the superconducting quantum circuit components are configured to make use of quantum-mechanical phenomena, such as superposition and entanglement, to perform operations on data in a non-deterministic manner. Certain superconducting quantum circuit components, such as qubits, may be configured to represent and operate on information in more than one state simultaneously. Examples of superconducting quantum circuit components include circuit elements such as quantum LC oscillators, qubits (e.g., flux qubits, phase qubits, or charge qubits), readout resonators, flux lines, readout transmission lines, co-planar waveguides, amplifiers, and superconducting quantum interference devices (SQUIDs) (e.g., RF-SQUID or DC SQUID), among others.

In contrast, classical circuit elements generally process data in a deterministic manner. Classical circuit elements may be configured to collectively carry out instructions of a computer program by performing basic arithmetical, logical, and/or input/output operations on data, in which the data is represented in analog or digital form. In some implementations, classical circuit elements may be used to transmit data to and/or receive data from the quantum circuit components through electrical or electromagnetic connections. Examples of classical circuit elements include circuit elements based on CMOS circuitry, rapid single flux quantum (RSFQ) devices, reciprocal quantum logic (RQL) devices and ERSFQ devices, which are an energy-efficient version of RSFQ that does not use bias resistors.

Any or all of the components mentioned in this disclosure, including the qubits, the readout resonators, the flux lines, the readout transmission lines, and the amplifiers, may be made of a superconductor material, such as aluminum, niobium, or titanium nitride, among other superconductor materials. The components may include both superconductor and non-superconductor material.

Fabrication of the electrical components disclosed herein may entail the deposition of one or more materials, such as superconductors, dielectrics and/or metals. Depending on the selected material, these materials can be deposited using deposition processes such as chemical vapor deposition, physical vapor deposition (e.g., evaporation or sputtering), or epitaxial techniques, among other deposition processes. Processes for fabricating electrical components described herein may entail the removal of one or more materials from a device during fabrication. Depending on the material to be removed, the removal process may include, e.g., wet etching techniques, dry etching techniques, or lift-off processes. The materials forming the electrical components described herein can be patterned using known lithographic techniques (e.g., photolithography or e-beam lithography). It should be noted that the processes for fabricating the electrical components described herein may further entail flip-chip manufacturing, where a device is flipped upside down and directly attached to another device, allowing for more efficient and compact packaging.

During operation of a quantum computational system that uses circuit elements formed, in part, from superconductors, such as the circuit elements described herein, the circuit elements are cooled down within a cryostat to temperatures that allow a superconductor material to exhibit superconducting properties. A superconductor (also referred to as superconducting) material may be understood as material that exhibits superconducting properties at or below a superconducting critical temperature. Examples of superconducting material include aluminum (superconductive critical temperature of 1.2 kelvin) and niobium (superconducting critical temperature of 9.3 kelvin). Accordingly, superconducting structures, such as superconducting traces and superconducting ground planes, are formed from material that exhibits superconducting properties at or below a superconducting critical temperature.

In certain implementations, control signals for the quantum circuit components (e.g., qubits and qubit couplers) may be provided using classical circuit elements that are electrically and/or electromagnetically coupled to the quantum circuit components. The control signals may be provided in digital and/or analog form.

While this specification contains many specific implementation details, these should not be construed as limitations on the scope of what may be claimed, but rather as descriptions of features that may be specific to particular implementations. Certain features that are described in this specification in the context of separate implementations may also be implemented in combination in a single implementation. Conversely, various features that are described in the context of a single implementation may also be implemented in multiple implementations separately or in any suitable sub-combination.

Although the exemplary embodiments of the invention are described herein, it should be noted that various changes and modifications could be made in the embodiments of the invention, without departing from the scope of legal protection which is defined by the appended claims. In the appended claims, the word "comprising" does not exclude other elements or operations, and the indefinite article "a" or "an" does not exclude a plurality. The mere fact that certain measures are recited in mutually different dependent claims does not indicate that a combination of these measures cannot be used to advantage.

Moreover, although features may be described above as acting in certain combinations and even initially claimed as such, one or more features from a claimed combination may in some cases be excised from the combination, and the claimed combination may be directed to a sub-combination or variation of a sub-combination.

Particular embodiments of the subject matter have been described. Other embodiments are within the scope of the following claims. For example, the actions recited in the claims may be performed in a different order and still achieve desirable results. As one example, the processes depicted in the accompanying figures do not necessarily require the particular order shown, or sequential order, to achieve desirable results.

### LIST OF REFERENCE SIGNS

| | |
|---|---|
| 100, 101, | superconducting chip |
| 102 | qubit |
| 103 | input terminal for control signal |
| 104 | substrate |
| 105 | termination to the ground |
| 106 | flux line |
| 107 | ground connection point |
| 108, 110, 808 | conductor arrangement |
| 400, 401, 600, 601, 800, 801, 1000, 1001 | superconducting chip packages |
| 402, 602, 802 | gap between substrates |
| 808 | bonding element |

## Claims

1. A superconducting chip, or chip package, comprising:
- at least one qubit (102) on a first substrate (104);
- at least one flux line (106) comprising an antinode for current in proximity of the at the at least one qubit;
- at least one termination to the ground (105) on an opposite side of the first substrate (104, 406) with respect to the at least one qubit or on a second substrate (406) stacked with the first substrate (104); and
- a conductor arrangement (108, 110, 808) connected to said one end of the flux line and arranged to route the flux line to the at least one termination to the ground (105).

2. The superconducting chip, or chip package, according to claim 1, wherein the conductor arrangement (108, 110) is configured to:
- extend through the first substrate (104); and
- connect the flux line (106) to the at least one termination to the ground (105) on the opposite side of the first substrate with respect to the at least one qubit.

3. The superconducting chip, or chip package, according to claim 1, wherein the conductor arrangement (108, 110) is configured to:
- extend through the second substrate (406); and
- connect the flux line (106) to the at least one termination to the ground (105) on the opposite side of the second substrate with respect to a side of the second substrate facing the at least one qubit.

4. The superconducting chip, or chip package, according to claim 1, wherein
- the conductor arrangement (108, 110, 808) is configured to:
- extend between the first substrate (104) and the second substrate (406); and
- connect the flux line to the at least one termination to the ground (105) on the second substrate (406).

5. The superconducting chip, or chip package, of any of the preceding claims, wherein the conductor arrangement is configured to connect flux line to at least one termination to the ground (105) through at least one of the following: at least one through-silicon via (TSV); or at least one bonding element (808); or a series of at least one through-silicon via (TSV) and at least one conductor line; or a series of at least one bonding element (808), at least one through-silicon via (TSV) and at least one conductor line.

6. A quantum computing apparatus comprising at least one superconducting chip, or chip package, according to any of claims 1 to 5, and a control unit connected to the at least one superconducting chip, or chip package, and the control unit is configured to feed one or more control signals to at least one flux line (106) for manipulating at least one qubit (102).
